# EUROPEAN PATENT SPECIFICATION

(11) **EP 0 495 447 B1**
(45) Date of publication and mention of the grant of the patent: **06.05.1999**
(21) Application number: 92100496.6
(22) Date of filing: 14.01.1992
(51) Int. Cl.: C23C 14/32, H01J 37/32

(54) **Method of controlling an arc spot in vacuum arc vapor deposition and an evaporation source**
Verfahren zur Steuerung eines Lichtbogenpunktes beim Vacuumbeschichten mittels Lichtbogenentladung und eine Verdampfungsquelle
Procédé pour commander un point à l'arc dans le dépôt sous vide par arc, et source d'évaporation

(30) Priority: 17.01.1991 JP 3944/91
(43) Date of publication of application: 22.07.1992
(73) Proprietor: KABUSHIKI KAISHA KOBE SEIKO SHO also known as Kobe Steel Ltd., Kobe 651 (JP)
(72) Inventor: Yoshikawa, Tetsuya, Kobe-shi, 658 (JP)
(74) Representative: Pellmann, Hans-Bernd, Dipl.-Ing.

(56) References cited:
- EP-A- 0 283 095
- WO-A-87/05948
- WO-A-87/05948
- WO-A-89/01699
- PATENT ABSTRACTS OF JAPAN vol. 14, no. 109 (C-695)(4052) 28 February 1990

## Description

### BACKGROUND OF THE INVENTION

### Field of the Invention

The present invention relates to an improved vacuum arc vapor deposition technique for forming a deposition film in vacuum on a substrate.

### Description of the Prior Art

The vacuum arc vapor deposition is fundamentally executed according to such a method as to evaporate an evaporation material from an evaporation source (cathode) by arc discharge in a vacuum chamber and to then deposit it on a substrate applied with a negative bias voltage, wherein the vapor of the cathodic material with a high energy is emitted as a plasma beam from a cathode as an evaporation source by a high arc current, and accelerated by a voltage applied between the cathode and the substrate to form a deposition film on the substrate (refer to Japanese Patent Publication Sho 58-3033).

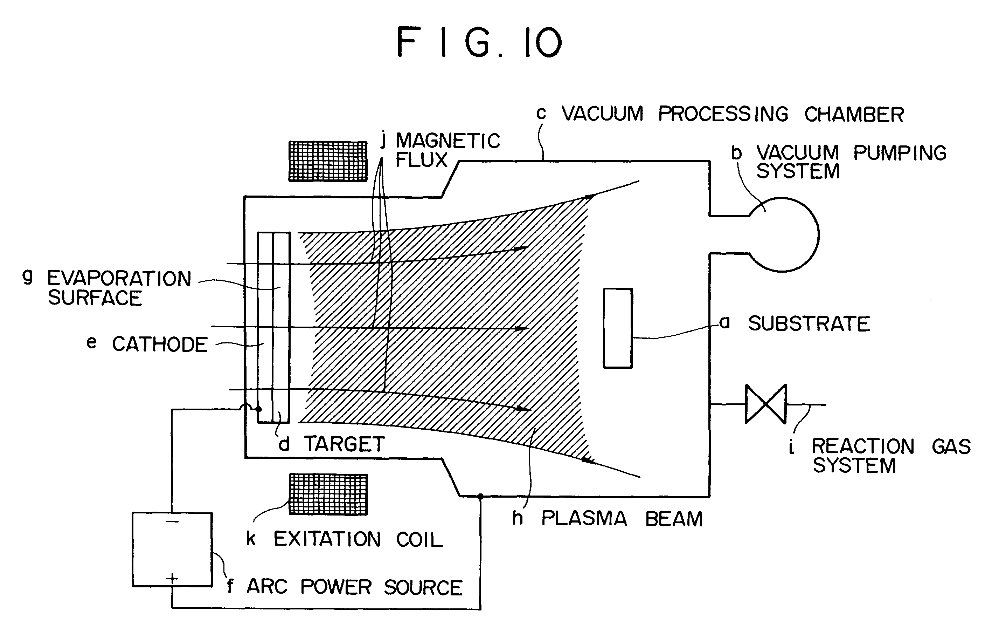

As an improved form of such a vacuum arc vapor deposition device, there has been known a device for introducing the plasma beam generated from the evaporation source by utilizing magnetic fields to improve the directionality thereof and effectively introducing the same to a substrate. Fig. 10 shows a typical example of such a device.

When a deposition film is formed on the surface of a substrate a as an object to be processed in this device, a target d of a conductive material as a film formation component is attached to a cathode e in a vacuum processing chamber c evacuated by a vacuum pumping system b, the vacuum processing chamber serving also as an anode in this embodiment and a cathode are connected to an arc power source f, vacuum arc discharge is caused between both of the electrodes by an arc discharge ignition means (not illustrated), the target material is evaporated and ionized from an arc spot formed on an evaporation surface q of the cathode, a plasma beam h is formed with the ions and electrons emitted from the arc spot and it is deposited on the surface of the substrate a. In this case, if necessary a negative voltage is applied to the substrate a, or a reaction gas introduced from a reaction gas system i and the vapor of the target material are brought into reaction to form a deposition film of a compound.

Further, in this device, magnetic fluxes j passing through the evaporation surface of the cathode are extended near the substrate and the plasma beam is introduced at a high directionality to the substrate by utilizing the nature of the plasmas that they tend to be introduced along the direction of the magnetic fluxes, to improve the film formation rate. For forming such magnetic fields, excitation coils k substantially in coaxial with the evaporation surface are disposed at a position near the evaporation surface of the cathode so as to surround the evaporation surface. In Fig. 10, the excitation coils k are disposed somewhat ahead of the evaporation surface, but they may be disposed at different positions depending on the purpose, with such a shape that the magnetic fluxes formed by the coils passes through the evaporation surface.

Application of magnetic fields to the vacuum arc vapor deposition technique are also made in various other modes.

Japanese Patent Laid-Open Hei 1-312067 discloses a vacuum arc vapor deposition device utilizing cusped magnetic fields in the prior art.

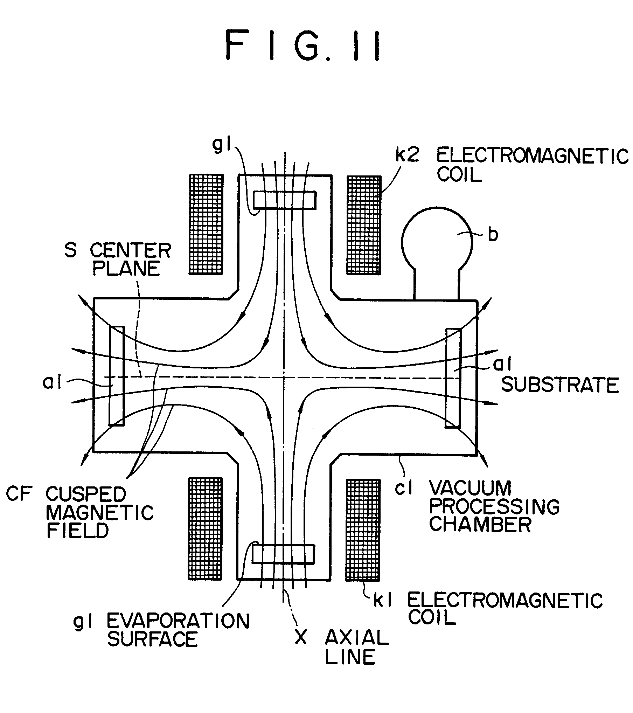

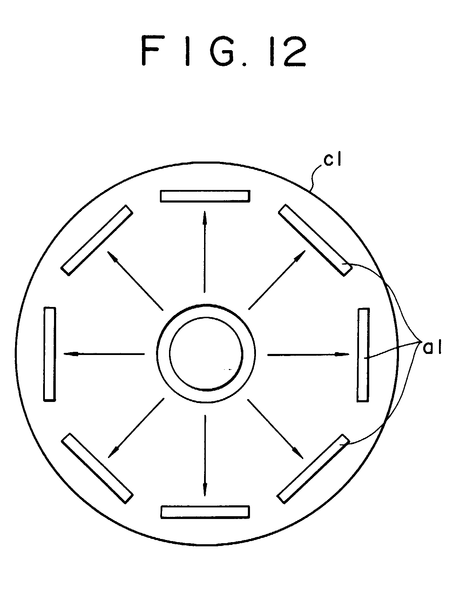

As shown in Figs. 11 and 12, the vacuum arc vapor deposition device comprises magnetic poles constituted with a pair of electromagnetic coils k1, k2 or permanent magnets opposed to each other at an identical polarity disposed along an identical axial line X in a vacuum processing chamber Cl having a cross shaped vertical cross section to form cusped magnetic fields CF in a space between both of the poles in the vacuum processing chamber. A vacuum arc evaporation source with a film formation material is disposed in the vicinity of at least one of positions where the cupsed magnetic fields are converged into a spot and the magnetic field intensity becomes maximum with an evaporation surface gl being directed to the center of the magnetic field. A substrate al is disposed in the vicinity of a position at the periphery of a central plane S along which the magnetic fields are diverged, and is further situated at such a non-perspective position as optically hidden from an evaporation source of the vacuum arc evaporation source by optical shield of intervening matters present therebetween.

In this device, a plasma stream having electric charges generated from the evaporation source by the vacuum arc flows out under the effect of the magnetic fields from the position on the central plane S along which the cusped magnetic fields are diverged and deposited to form a film on the substrate, while neutral macroparticles proceed straight forward free from the effect of the magnetic fields and are prevented from intruding into the deposition film on the substrate situated at a shielded position.

In the vacuum arc vapor deposition device of the prior art described above, since an arc spot formed by the vacuum arc that causes evaporation from the evaporation source has a nature of displacing at random on the evaporation surface, the arc spot can not be controlled to be present only in a specified local region on the evaporation surface. Accordingly, evaporation occurs from the entire area of the evaporation surface to make the plasma beam diverged widely as shown in Fig. 11.

In a case where the substrate to be processed is relatively small as compared with the extent of the plasma beam, a considerable portion of the plasmas evaporated from the evaporation surface can not reach the substrate but are merely deposited wastefully on each of the portions in the vacuum processing chamber. Further, it is also difficult to focus the plasma beam at a high plasma density to a restricted portion.

In addition, in the vacuum arc vapor deposition device using cusped magnetic fields shown in Figs. 11 and 12, since the evaporation surface gl of the evaporation source and the magnetic field generation coils k1, k2 are on the central axial line X, the substrates al have to be disposed so as to be at the entire circumferential positions around the central axial line as shown in Fig. 12.

However, in a case where the number of substrates to be processed is small, since it is impossible to surround the entire circumference of a large diameter at the periphery of the central axial line with no wasteful gaps, most of evaporation products such as ions can not be vapor deposited on the substrate but wastefully consumed by being deposited to the inner walls of the vacuum chamber cl, which brings about a problem of lowering the vapor deposition efficiency.

Document WO-A8 705 948 discloses a process for arc coating alloy nitride films on objects using a cathode or target composed of separate sections of the two metals from which the alloy is to be formed and a steered arc that is controlled in its path across the target along a controlled arc trajectory to provide a controlled coating composition with reproducible results.

Document WO-A-8 901 699 discloses a process and an apparatus for controlled arc coating of substrates utilizing relatively thick anodes or targets for obtaining coatings which are free of macro-particles. The thick targets are capable of use by controlling and steering the arc in a desired path as necessary to produce coatings of the desired compositions using magnetic field generated to provide arc path control and modulation for efficient target utilization.

Document JP-A-1 312 067 discloses a vacuum arc vapor deposition apparatus comprising a vacuum treatment chamber having a shape of a rotor with a cruciform section. Cusp-shaped magnetic fields are generated by means of excitation of coils provided in opposition to each other at the upper and lower parts of the chamber. Vacuum arc evaporation sources are provided, respectively, to the close vicinities of the positions where the intensity of the magnetic fields is maximal so that the evaporation surfaces of the above evaporation sources are allowed to face the magnetic fields, and substrates are disposed, respectively, in the positions in which the magnetic fields diverge and which are optically shaded from the evaporation sources. When the evaporation sources are ignited in the above constitution and film-forming materials are evaporated, a plasma consisting of the ions of the evaporated materials is allowed to flow efficiently via the magnetic fields to the substrates. On the other hand, molten grains are not ionized, and are allowed to proceed straight independently of the magnetic fields and stopped by the collision with the walls of the treatment chamber, and as a result, these molten grains are not deposited on the substrates.

### SUMMARY OF THE INVENTION

The present invention has been accomplished with an aim of solving the forgoing problems in the prior art and enabling control of an arc sport to be focused, control of the arc spot for the position of the focused region, as well as high density converging of plasma beam.

This object is achieved by a vacuum arc vapor deposition method according to claim 1.

The method of controlling the arc spot is characterized in that, in a vacuum arc vapor deposition device comprising excitation coils disposed near the evaporation surface of a cathode as a vacuum arc evaporation source substantially in coaxial with the evaporation surface, so as to surround it, and a first magnetic fields passing through the evaporation surface are formed by excitation, an additional magnetic field generation source comprising small excitation coils or permanent magnets that generate magnetic fields in the direction opposite to that of the first magnetic fields is disposed near the rear side of the evaporation surface, to operate them in combination.

By the method of controlling the arc spot and the evaporation source for enabling to practice the method according to the present invention, the arc spot causing the evaporation from the evaporation surface can be induced to a restricted region of the evaporation surface ahead of the additional magnetic field generation source.

The function will be now described.

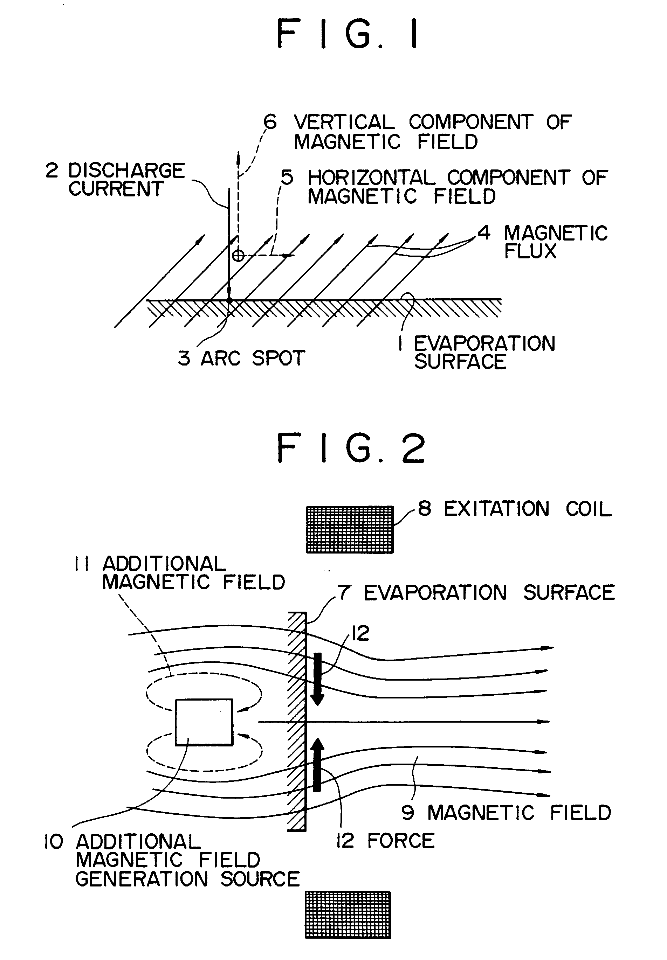

Assuming, at first as shown in Fig. 1, that an arc spot 3 of a vacuum arc is formed on an evaporation surface 1 of a cathode and there are present magnetic fluxes 4 passing through the evaporation surface at an angle, it has been known that the arc spot moves under the interaction between the horizontal component 5 of the magnetic fields and the current 2 flowing through the arc spot, while undergoing an electromagnetic force in the direction perpendicular to both of them, that is, in the direction perpendicular to the sheet of drawing in Fig. 1, as well as tends to move under the effect of the vertical component 6 of the magnetic fields in a case where magnetic fluxes pass through the evaporation surface at an angle of inclination in the direction where the magnetic fluxes are inclined at an acute angle relative to the evaporation surface, that is, in the rightward direction in Fig. 1 (refer to U.S. Patent No. 2,972,695).

Referring then to the present invention, as shown in Fig. 2, excitation coils 8 substantially coaxial with an evaporation surface 7 of a cathode as a vacuum arc evaporation source are disposed near the evaporation surface 7 so as to surround the evaporation surface and, they are excited to generate a first magnetic field comprising magnetic fluxes that pass through the evaporation surface. Further, an additional magnetic field generation source 10 for generating magnetic fluxes in the direction opposite to the first magnetic field is disposed in the vicinity of the rear side of the evaporation surface to generate an additional magnetic field 11 shown by the dotted line. When they are combined to each other, magnetic fluxes 9 extended outward near the additional magnetic generation source are formed, and a distribution shape of magnetic fluxes directing to the central axis are obtained near the evaporation surface by the magnetic fluxes. Considering the above-mentioned shape together with the fact that the arc spot undergoes the force in the direction of making an acute angle formed when the magnetic fluxes pass through the evaporation surface as explained with reference to Fig. 1, the arc spot undergoes a force 12 shown by fat arrows toward the region ahead of the additional magnetic field generation source on the evaporation surface.

As has been described above, the arc spot of the vacuum arc vapor deposition in the present invention does not move around at random over the entire region of the evaporation surface as in the prior art but it is trapped so as to be confined within a restricted region in the vicinity ahead of the additional magnetic field generation source on the rear side of the evaporation surface, so that evaporation of the film formation material occurs only at the focused region.

The effect of the present invention is confirmed not only theoretically but also experimentally, and it has been observed that the arc spot is trapped and moves circumferentially at a high speed in a small region on the evaporation surface ahead of the additional magnetic field generation source of the permanent magnets. Further, it has also been confirmed that the extent of the region in which the arc spot is trapped varies by changing the distance between the additional magnetic field generation source and the evaporation source and that the extent of the region in which the arc spot is trapped varies by changing the disposing position and the excitation intensity of the additional magnetic field generation source, as well as it has been found that the controllability is also excellent.

### BRIEF DESCRIPTION OF THE DRAWINGS

Fig. 1 is an explanatory view illustrating the effect of magnetic fluxes exerted on an arc spot on an evaporation surface;
Fig. 2 is a view illustrating the shape of magnetic fluxes generated on the evaporation surface in the present invention;
Fig. 3 is a vertical cross sectional view of a device as an typical embodiment according to the present invention;
Fig. 4 is an enlarged cross sectional view for a portion of a second embodiment illustrating the state of mounting an additional magnetic field generation source according to the present invention;
Fig. 5 is a top plan view for the mounting portion in the second embodiment;
Fig. 6 is an enlarged cross sectional view for a portion of a third embodiment illustrating the additional magnetic field generation source according to the present invention;
Fig. 7 is a plan view of a mosaic composite target used in the third embodiment of the present invention;
Fig. 8 is a vertical cross sectional view of a fourth embodiment using cusped magnetic fields according to the present invention;
Fig. 9 is a transversal cross sectional view at the central plane in the device shown in Fig. 8;
Fig. 10 is a vertical cross sectional view of a vacuum arc vapor deposition device as one embodiment of the prior art;
Fig. 11 is a vertical cross sectional view of a device using a cusped magnetic field as another embodiment of the prior art; and
Fig. 12 is a transversal cross sectional view at the central plane of the device shown in Fig. 10.

### DESCRIPTION OF THE PREFERRED EMBODIMENTS

The present invention will now be described more specifically by way of the embodiments with reference to the drawings. Further, additional advantages obtained by the device in each of the embodiments will be shown together.

### [Embodiment 1]

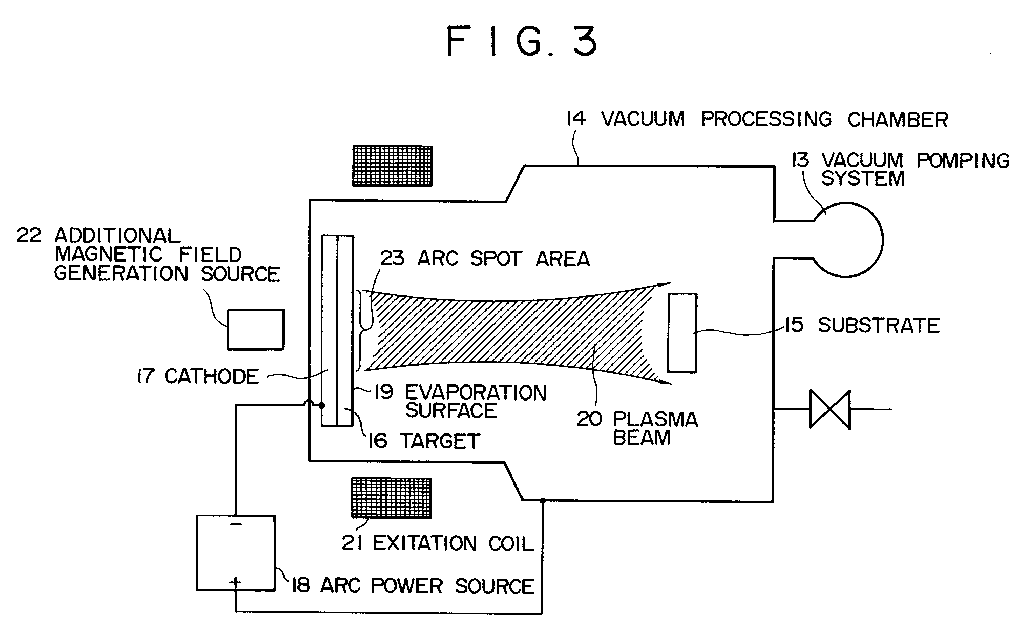

Fig. 3 shows a typical embodiment of a device used for practicing the present invention. The device is identical, as a whole, with the device of the prior art shown in Fig. 10, in which a substrate 15 as an object to be processed is contained in a vacuum processing chamber 14 evacuated by a vacuum pumping system 13, a target 16 composed of a film formation material is attached to a cathode 17 being opposed thereto, the vacuum processing chamber also serving as an anode and a cathode are connected to an arc power source 18, arc discharge is caused by an arc discharge ignition means between both of the poles, and the film formation material is evaporated by the arc spot from the evaporation surface 19 of the cathode, to form a plasma beam 20.

Excitation coils 21 are disposed surrounding the evaporation surface 19 and are excited to form magnetic fields in which the magnetic fluxes pass through the evaporation surface of the cathode. An additional magnetic field generation source 22 comprising permanent magnets is disposed near the rear side of the evaporation surface to generate magnetic fields in the direction opposite to that of the magnetic fields described previously for practicing the present invention.

The permanent magnets may be replaced with electromagnetic coils for generating similar magnetic fields.

The arc spot causing evaporation of the film formation material from the evaporation surface is trapped by an orbit drawing a circle in a small arc spot region 23 on the evaporation surface ahead of the additional magnetic field generation source 22 by the cooperation between both of the magnetic fields. The plasma beam 20 generated from the arc spot trapped in the small region also undergoes induction by the magnetic field substantially is perpendicular to the first evaporation surface to form a strongly directing converged beam shown in the figure, and introduced on the substrate to form a deposition film.

Accordingly, a deposition film can be formed efficiently even in a case where the substrate is small and, since the density of the plasmas obtained near the substrate is high, a deposition film at a high quality can be formed.

### [Embodiment 2]

The present invention can provide various other additional advantages depending on the mode of disposing the additional magnetic field generation source.

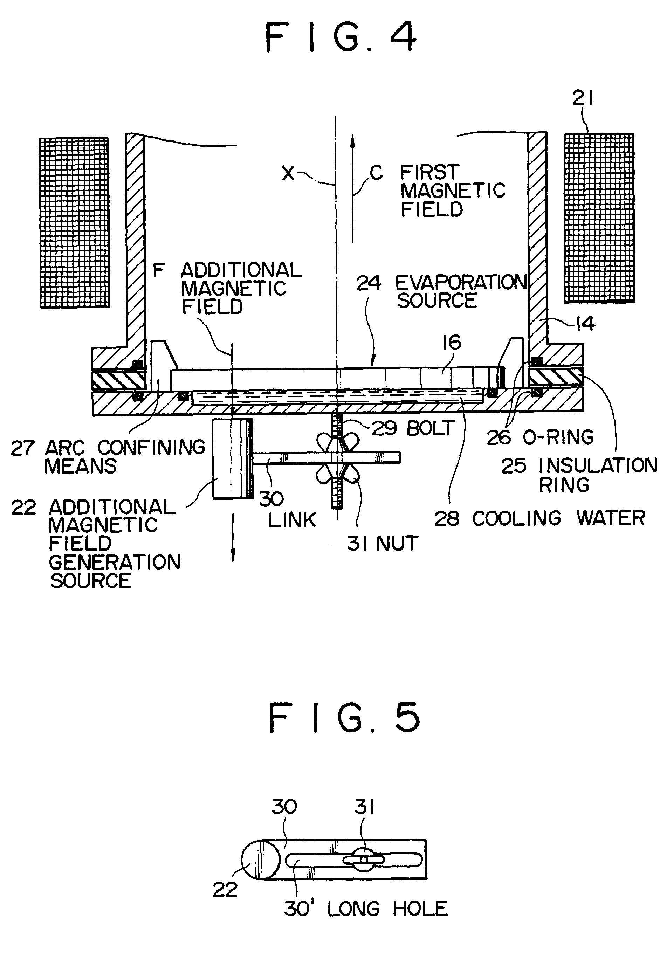

Figs. 4 and 5 show enlarged cross sectional views for a portion in which an additional magnetic field generation source 22 comprising permanent magnets is disposed vertically. In the figures, components and members identical with those in Embodiment 1 shown in Fig. 3 carry the same reference numerals with no duplicate descriptions.

A target 16 of an evaporation source 24 for vacuum arc vapor deposition is attached to a vacuum processing chamber 14 by means of an insulation ring 25 while being sealed by an 0-ring 26. A target for a film formation material is attached on the surface being surrounded with an arc confining means 27, and cooled by cooling water 28 passing the rear side thereof. A bolt 29 is disposed at a position for the central axis X on the rear side of the evaporation source, and a link 30 having a long hole 30' secured to the additional magnetic field generation source 22 of the permanent magnets is clamped by nuts 31 and attached to the bolt 29.

The direction of the additional magnetic field F by the additional magnetic field generation source 22 is made opposite to the direction of the first magnetic field C generated from the excitation coils 21.

With such a structure, the additional magnetic field generation source 22 of the permanent magnets can be set on the rear side of the target 16 of the evaporation surface while being moved optionally both in the radial direction and the circumferential direction independently. The arc spot can be controlled to a desired position within the evaporation surface in accordance with the movement of the generation source 22. Further, the distance of the additional magnetic field generation source from the evaporation surface can also be varied with ease, by which the size of a region to which the arc spot is trapped in the evaporation surface and, accordingly, the converging degree, that is, the intensity of the plasma beam can be varied to adapt it to the size of the substrate. The excitation intensity or the shape of the additional magnetic field generation source can be changed by replacing the permanent magnets. The same effect can be attained also by using electromagnetic coils instead of the permanent magnets.

### [Embodiment 3]

The additional magnetic field generation source is semi-fixed in Embodiment 2, but a preferred result can be obtained, in a case where the target of the cathode is circular, by rotationally driving the magnetic field generation source coaxially with the circular evaporation surface using a driving source.

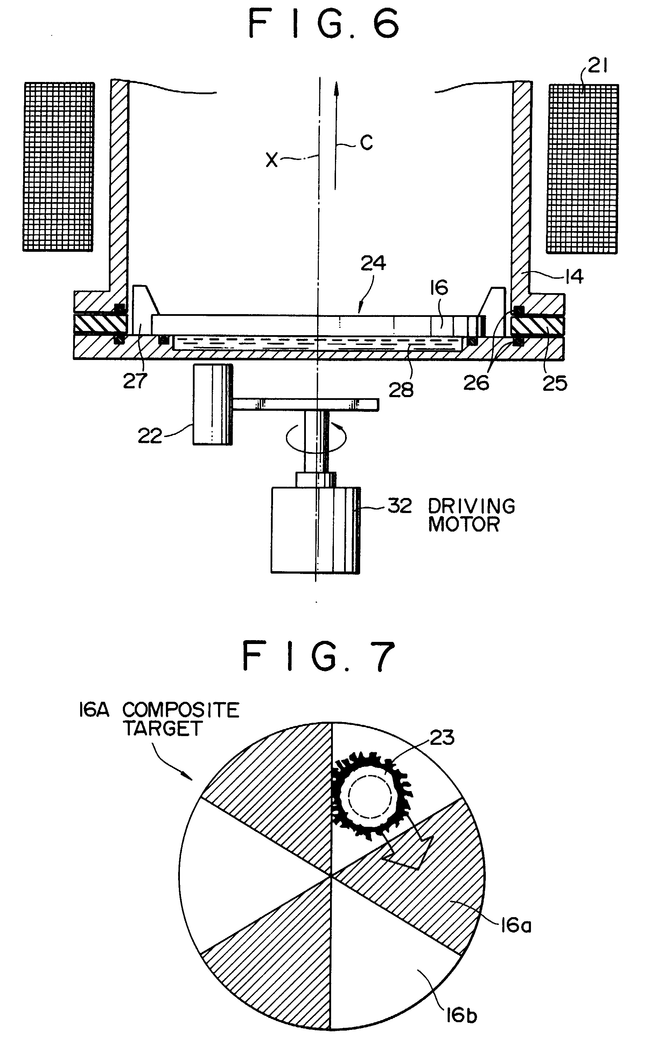

Fig. 6 shows such an embodiment, in which identical components and members with those in the previous embodiment carry the same reference numerals with no duplicate descriptions. In this example, an additional magnetic field generation source 22 is rotationally moved around a central axis X by a driving motor 32.

In the prior art, since the arc spot basically moves at random on the evaporation surface, the central portion is mainly evaporated to be consumed sooner or the arc spot is localized to consume only a portion greatly. In Embodiment 3 of the present invention, since the arc spot is trapped in a region of an appropriate size and the region is moved circumferentially on the evaporation surface, the target can be consumed extremely uniformly to improve the efficiency of utilizing the material.

In the device shown in Fig. 6, a deposition film comprising alloying elements can be obtained stably by constituting a target into a composite target 16A in which two or more kinds of film formation materials 16a, 16b are combined in a mosaic form as shown in Fig. 7. In the prior art, since the arc spot often concentrates on the material, among two or more kind of materials, that can be present stably, the composition of the deposition film may possibly be deviated from the aimed one. However, in the present invention, since the region 23 in which the arc spot is present is controlled properly and the region is moved rotationally In this embodiment, both of the materials 16a, 16b can be evaporated uniformly to stabilize the composition of the deposition film.

As a further application of this example, deposition films of different compositions can be obtained stably by controlling the moving speed of the additional magnetic field generation source depending on the angular position.

### [Embodiment 4]

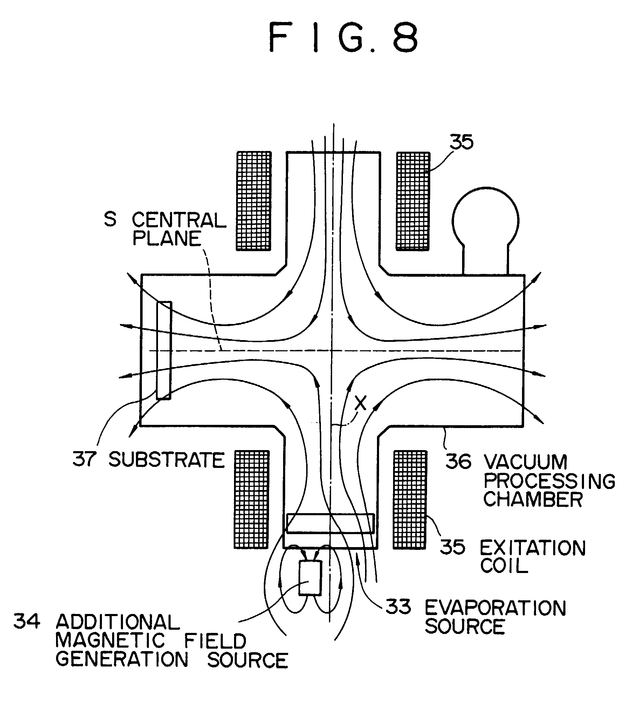

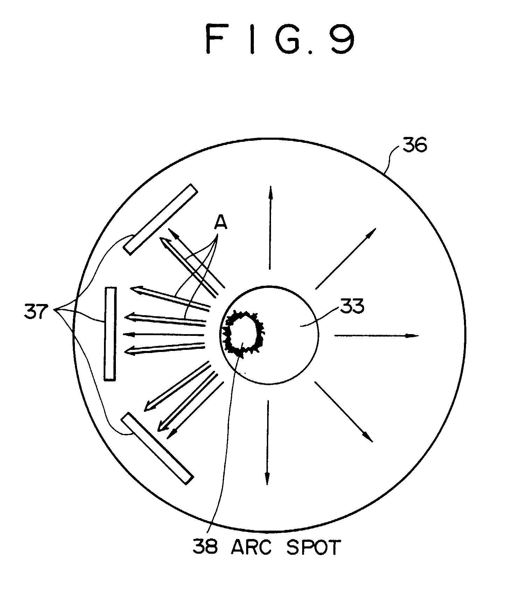

The present invention is applicable also to a vacuum arc vapor deposition device using the cusped magnetic fields. Fig. 8 and 9 illustrate such an embodiment, in which identical components and members with those shown in Figs. 11 and 12 for the prior art carry the same reference numerals with no duplicate descriptions.

In this example, a bar-shaped permanent magnet is attached at a position just in the vicinity on the rear side of an evaporation source 33 while being deviated from a central axis X to constitute an additional magnetic field generation source 34. The direction of the additional magnetic field F generated is made opposite to the direction of the primary magnetic field caused by excitation coils 35. The additional magnetic field generation source 34 may be electromagnetic coils instead of the permanent magnet so long as the foregoing conditions can be satisfied.

A substrate 37 is disposed in the periphery of a position on the central plane S along which cusped magnetic fields are diverged in a vacuum processing chamber 36 at a position optically shielded from an evaporation source by the walls of the vacuum processing chamber 36. In this embodiment, three substrates 37 are disposed each being deviated in the same direction as the direction along which the additional magnetic fields generation source 34 is deviated from the central axis X.

In the device of this embodiment, an arc spot 38 appearing on the evaporation surface of the evaporation source 33 by vacuum arc discharge is trapped by an orbit drawing a circle near the position on which the additional magnetic field generation source 34 is disposed as shown in Fig. 9. Since the plasma beam generated from the evaporation surface by the arc spot is induced along the magnetic fluxes of the magnetic field deviated from the symmetric cusped shape shown in Fig. 8, plasmas fly mainly leftward as shown by fat arrows A in Fig. 9 and contribute to the vapor deposition to the three substrates disposed in this direction. That is, vapor deposition products flying in the direction in which no substrates are present can be minimized to improve the efficiency for the vapor deposition. Further, by making the additional magnetic field generation 34 movable as in the embodiments shown in Figs. 4 and 8, it is possible to scan the plasmas and control the localized position for vapor deposition.

As has been described above according to the present invention, since the arc spot can be controlled to a predetermined region on the evaporation surface, a converged high density plasma beam can be obtained and a deposition film can be formed even on a small substrate with less loss and at high quality. In addition, being coupled with the improvement for the constitution of the device, there can be obtained various advantages capable of optionally controlling the position and the size of the plasma beam, making the consumption of the target uniform and stabilizing the composition of the alloyed deposition film.

A vacuum arc vapor deposition device comprising a vacuum processing chamber, a vacuum arc evaporation source disposed in the vacuum processing chamber, excitation coils disposed to the outside of the vacuum processing chamber so as to surround the evaporation surface of a cathode in the vacuum arc evaporation source, and an additional magnetic field generation source disposed near the rear side of the evaporation surface.

By the combination of a magnetic field formed with the excitation coils and an opposite magnetic field formed with the additional magnetic field generation source, efficient use of the evaporation source target, use of a plurality of materials, effective converging of the plasma beam and efficient deposition to the substrate can be attained.

## Claims

1. A vacuum arc vapor deposition method comprising the steps of
arranging a vacuum arc evaporation source (24) and a substrate (15) to be vapor deposited in a vacuum processing chamber (14),
arranging an excitation coil (21) so as to surround an evaporation surface (19) of said vacuum arc evaporation source,
arranging an additional magnetic field generation source (22) near a rear surface of said vacuum arc evaporation source,
forming a first magnetic field by means of said excitation coil guiding a plasma beam from said vacuum arc evaporation source toward said substrate to be vapor deposited,
forming an additional magnetic field by means of said additional magnetic field generation source so that the combination of said first magnetic field and said additional magnetic field results in a distribution shape of magnetic fluxes directing to the central axis of said evaporation surface and in an effective converging of the plasma beam.

2. A vacuum arc vapor deposition method as defined in claim 1, wherein the additional magnetic field generation source comprises permanent magnets.

3. A vacuum arc vapor deposition method as defined in claim 1, wherein the additional magnetic field generation source comprises electromagnetic coils.

4. A vacuum arc vapor deposition method as defined in claim 1, wherein the magnetic field formed by the excitation coils has a cusped shape.

5. A vacuum arc vapor deposition method as defined in one of claims 1-4, wherein the additional magnetic field generation source is disposed just in the vicinity on the rear side of the vacuum arc evaporation source being deviated from the central axis of the vacuum arc evaporation source.

6. A vacuum arc vapor deposition method as defined in claim 5, wherein the substrate to be vapor deposited with vapor of a film formation material from the vacuum arc evaporation source is attached at a position optically shielded from the vacuum arc evaporation source by the wall of the vacuum processing chamber.

7. A vacuum arc vapor deposition method as defined in claim 1, wherein the additional magnetic field generation source is held by an additional magnetic field generation source holding means disposed on the rear side of the evaporation source.

8. A vacuum arc vapor deposition method as defined in claim 7, wherein the additional magnetic field generation source holding means comprises a link having a long hole and attached to the additional magnetic field generation source, a bolt disposed to the rear side of the evaporation source and passing through said link having the long hole and a plurality of nuts for engagement with said bolt.

9. A vacuum arc vapor deposition method as defined in claim 7, wherein the additional magnetic field generation source holding means is connected with a driving motor, so that the additional magnetic field generation source is rotationally moved around the central axis of the evaporation source.

10. A vacuum arc vapor deposition method as defined in claim 9, wherein the moving speed of the additional magnetic field generation source is controlled depending on the angular position.

11. A vacuum arc vapor deposition method as defined in claim 9, wherein a target disposed to the vacuum arc evaporation source is a composite target comprising a plurality of film formation materials combined in a mosaic form.

12. Use of a vacuum arc vapor deposition device for carrying out the vacuum arc vapor deposition method according to one of the preceding claims, said device comprising a vacuum processing chamber (14), a vacuum arc evaporation source (24), excitation coils (21) and an additional magnetic field generation source (22).

## Patentansprüche

1. Vakuum-Lichtbogenbedampfungsverfahren mit den Schritten:
Anordnen einer Vakuum-Lichtbogenverdampfungsquelle (24) und eines aufzudampfenden Substrats (15) in einer Vakuum-Behandlungskammer (14),
Anordnen einer Erregerspule (21), so daß sie eine Verdampfungsfläche (19) der Vakuum-Lichtbogenverdampfungsquelle umgibt,
Anordnen einer zusätzlichen Magnetfelderzeugungsquelle (22) in der Nähe einer rückwärtigen Fläche der Vakuum-Lichtbogenverdampfungsquelle,
Ausbilden eines ersten Magnetfelds mittels der Erregerspule, die einen Plasmastrahl von der Vakuum-Lichtbogenverdampfungsquelle in Richtung auf ein zu bedampfendes Substrat leitet,
Ausbilden eines zusätzlichen Magnetfelds mittels der zusätzlichen Magnetfelderzeugungsquelle, so daß die Kombination des ersten Magnetfelds und des zusätzlichen Magnetfelds eine zu der zentralen Achse der Verdampfungsfläche gerichtete Verteilungsgestalt der magnetischen Flüsse und ein effektives zusammenlaufen des Plasmastrahls zum Ergebnis hat.

2. Vakuum-Lichtbogenbedampfungsverfahren nach Anspruch 1, wobei die zusätzliche Magnetfelderzeugungsquelle Permanentmagneten aufweist.

3. Vakuum-Lichtbogenbedampfungsverfahren nach Anspruch 1, wobei die zusätzliche Magnetfelderzeugungsquelle elektromagnetische Spulen aufweist.

4. Vakuum-Lichtbogenbedampfungsverfahren nach Anspruch 1, wobei das durch die Erregerspule ausgebildete Magnetfeld eine spitz zulaufende Gestalt hat.

5. Vakuum-Lichtbogenbedampfungsverfahren nach einem der Ansprüche 1 bis 4, wobei die zusätzliche Magnetfelderzeugungsquelle in nächster Nähe auf der Rückseite der Vakuum-Lichtbogenverdampfungsquelle und von der zentralen Achse der Vakuum-Lichtbogenverdampfungsquelle versetzt angeordnet ist.

6. Vakuum-Lichtbogenbedampfungsverfahren nach Anspruch 5, wobei das mit einem Gas von einem Filmausbildungsmaterial von der Vakuum-Lichtbogenverdampfungsquelle zu beschichtende Substrat an einer Position angebracht ist, die von der Vakuum-Lichtbogenverdampfungsquelle durch eine Wand der Vakuum-Behandlungskammer optisch abgeschirmt ist.

7. Vakuum-Lichtbogenbedampfungsverfahren nach Anspruch 1, wobei die zusätzliche Magnetfelderzeugungsquelle durch eine Halteeinrichtung für eine zusätzliche Magnetfelderzeugungsquelle an der Rückseite der Verdampfungsquelle gehalten wird.

8. Vakuum-Lichtbogenbedampfungsverfahren nach Anspruch 7, wobei die Halteeinrichtung für eine zusätzliche Magnetfelderzeugungsquelle ein Verbindungsglied, das ein Langloch hat und an der zusätzlichen Magnetfelderzeugungsquelle angebracht ist, einen Bolzen, der auf der Rückseite der Verdampfungsquelle angeordnet ist und das Verbindungsglied mit dem Langloch durchdringt, und eine Mehrzahl von Muttern zum Eingreifen mit dem Bolzen hat.

9. Vakuum-Lichtbogenbedampfungsverfahren nach Anspruch 7, wobei die Halteeinrichtung für die zusätzliche Magnetfelderzeugungsquelle mit einem Antriebsmotor verbunden ist, so daß die zusätzliche Magnetfelderzeugungsquelle um die zentrale Achse der Verdampfungsquelle drehend bewegt wird.

10. Vakuum-Lichtbogenbedampfungsverfahren nach Anspruch 9, wobei die Bewegungsgeschwindigkeit der zusätzlichen Magnetfelderzeugungsquelle in Abhängigkeit von einer Winkelposition gesteuert wird.

11. Vakuum-Lichtbogenbedampfungsverfahren nach Anspruch 9, wobei eine an der Vakuum-Lichtbogenverdampfungsquelle angeordnete Scheibe eine zusammengesetzte Scheibe mit einer Mehrzahl von Filmausbildungsmaterialien ist, die in einer Mosaikgestalt zusammengesetzt sind.

12. Verwendung einer Vakuum-Lichtbogenbedampfungsvorrichtung zum Ausführen des Vakuum-Lichtbogenbedampfungsverfahrens nach einem der vorangehenden Ansprüche, wobei die Vorrichtung eine Vakuum-Behandlungskammer (14), eine Vakuum-Verdampfungsquelle (24), Erregerspulen (21) und eine zusätzliche Magnetfelderzeugungsquelle (22) hat.

## Revendications

1. Procédé de dépôt de vapeur par arc sous vide comprenant les étapes de :
mise en place d'une source d'évaporation par arc sous vide (24) et d'un substrat (15) devant être soumis à un dépôt de vapeur dans une chambre de traitement sous vide (14),
mise en place d'une bobine d'excitation (21) de façon à entourer une surface d'évaporation (19) de ladite source d'évaporation par arc sous vide,
mise en place d'une source génératrice de champ magnétique supplémentaire (22) à proximité d'une surface arrière de ladite source d'évaporation par arc sous vide,
formation d'un premier champ magnétique au moyen de ladite bobine d'excitation en guidant un faisceau de plasma provenant de ladite source d'évaporation par arc sous vide vers ledit substrat devant être soumis à un dépôt de vapeur,
formation d'un champ magnétique supplémentaire au moyen de ladite source génératrice de champ magnétique supplémentaire afin que la combinaison dudit premier champ magnétique et dudit champ magnétique supplémentaire conduise à une forme de distribution de flux magnétiques dirigés vers l'axe central de ladite surface d'évaporation et à une convergence efficace du faisceau de plasma.

2. Procédé de dépôt de vapeur par arc sous vide selon la revendication 1, dans lequel la source génératrice de champ magnétique supplémentaire comprend des aimants permanents.

3. Procédé de dépôt de vapeur par arc sous vide selon la revendication 1, dans lequel la source génératrice de champ magnétique supplémentaire comprend des bobines électromagnétiques.

4. Procédé de dépôt de vapeur par arc sous vide selon la revendication 1, dans lequel le champ magnétique formé par les bobines d'excitation présente une forme cuspidée.

5. Procédé de dépôt de vapeur par arc sous vide selon l'une des revendications 1-4, dans lequel la source génératrice de champ magnétique supplémentaire est disposée au voisinage immédiat de la face arrière de la source d'évaporation par arc sous vide en étant décalée de l'axe central de la source d'évaporation par arc sous vide.

6. Procédé de dépôt de vapeur par arc sous vide selon la revendication 5, dans lequel le substrat devant être soumis à un dépôt de vapeur avec la vapeur d'un matériau de formation de film provenant de la source d'évaporation par arc sous vide, est fixé à une position optiquement occultée de la source d'évaporation par arc sous vide par la paroi de la chambre de traitement sous vide.

7. Procédé de dépôt de vapeur par arc sous vide selon la revendication 1, dans lequel la source génératrice de champ magnétique supplémentaire est maintenue par un moyen de maintien de source génératrice de champ magnétique supplémentaire disposé sur la face arrière de la source d'évaporation.

8. Procédé de dépôt de vapeur par arc sous vide selon la revendication 7, dans lequel le moyen de maintien de source génératrice de champ magnétique supplémentaire comprend un lien ayant un trou oblong et fixé à la source génératrice de champ magnétique supplémentaire, un boulon disposé sur la face arrière de la source d'évaporation et passant à travers ledit lien comportant le trou oblong et une pluralité d'écrous destinés à s'engager sur ledit boulon.

9. Procédé de dépôt de vapeur par arc sous vide selon la revendication 7, dans lequel le moyen de maintien de source génératrice de champ magnétique supplémentaire est relié à un moteur d'entraînement, de façon à ce que la source génératrice de champ magnétique supplémentaire soit déplacée en rotation autour de l'axe central de la source d'évaporation.

10. Procédé de dépôt de vapeur par arc sous vide selon la revendication 9, dans lequel la vitesse de déplacement de la source génératrice de champ magnétique supplémentaire est commandée en fonction de la position angulaire.

11. Procédé de dépôt de vapeur par arc sous vide selon la revendication 9, dans lequel une cible disposée en face de la source d'évaporation par arc sous vide est une cible composite comprenant une pluralité de matériaux de formation de film combinés sous une forme mosaïque.

12. Utilisation d'un dispositif de dépôt de vapeur par arc sous vide pour mettre en oeuvre le procédé de dépôt de vapeur par arc sous vide selon l'une des revendications précédentes, ledit dispositif comprenant une chambre de traitement sous vide (14), une source d'évaporation par arc sous vide (24), des bobines d'excitation (21) et une source génératrice de champ magnétique supplémentaire (22).
